# EUROPEAN PATENT APPLICATION

(11) **EP 4 374 978 A1**
(43) Date of publication of application: **29.05.2024**
(21) Application number: 23208596.9
(22) Date of filing: 08.11.2023
(51) Int. Cl.: B09B 3/35, B09B 3/70, B29B 17/02, C08J 11/04

(54) **METHOD FOR RECOVERING FLUORINE FROM BACKSHEET USED IN SOLAR PANEL AND METHOD FOR PRODUCING CALCIUM FLUORIDE**

(30) Priority: 25.11.2022 JP 2022188691
(71) Applicant: Dowa Eco-System Co., Ltd., Tokyo 101-0021 (JP); Tohoku University, Sendai-shi, Miyagi 980-8577 (JP)
(72) Inventor: MORITA, Yoshinori, Tokyo, 101-0021 (JP); WATANABE, Ryoei, TOkyo, 101-0021 (JP); YOSHIOKA, Toshiaki, Miyagi, 980-8577 (JP); KUMAGAI, Shogo, Miyagi, 980-8577 (JP); SAITO, Yuko, Miyagi, 980-8577 (JP)
(74) Representative: Müller-Boré & Partner Patentanwälte PartG mbB

(57) **Abstract**

There is provided a method for recovering fluorine from a backsheet used in a solar panel, which is a method for recovering fluorine from fluoropolymer of the backsheet containing the fluoropolymer and PET which are used in a solar panel, the method including: applying alkaline treatment to the fluoropolymer to separate fluorine in a presence of a catalyst; and causing a reaction between calcium and the separated fluorine to recover the fluorine as calcium fluoride.

## Description

### Background

### Technical Field

The present invention relates to a method for recovering fluorine from a backsheet used in a solar panel, and a method for producing calcium fluoride.

### Description of related art

In a solar cell power generation, a clean energy of sunlight is used because of a small environmental load, so the solar cell power generation is attracting attention as a renewable energy source. A solar panel used in this solar power generation includes for example: a glass substrate, a solar battery cell, an encapsulant for sealing the solar battery cell, a backsheet, a metal pattern wired from the solar battery cell, a frame member provided around the encapsulant, etc.

In the past, the solar panel was disposed of after being used in a certain period of time, but in recent years, there is a demand for recovering a valuable substance from a viewpoint of recycling.

### Prior art document

### Patent document

[Patent Document 1] JP-A-2007-180063

### Summary of the invention

### Problem to be solved by the invention

The present inventors paid attention to fluorine contained in fluoropolymer used in a backsheet of a solar panel, etc., as a valuable substance.

This is because increase of the demand for fluoropolymer is expected in the future due to the spread of solar panels. On the other hand, fluorite (main component is calcium fluoride), which is a major source of fluorine, is evaluated as a resource with high supply risk worldwide because producing countries are concentrated in specific regions. Therefore, the method of recovering fluorine contained in fluoropolymer enables the recycling of fluorine from a used solar panel and contributes to a sustainable production and consumption of fluoropolymer.

However, there is no effective method for recovering fluorine from fluoropolymer used in a solar panel.

For example, patent document 1 proposes a method for dismantling a solar cell module, that suppresses cracking and chipping of solar cell elements and improves a recovery rate of the solar cell elements when recovering the solar cell elements from solar cell modules. However, the proposal of patent document 1 aims at collecting solar cell elements, and the fluoropolymer contained in the backsheet, etc., is thermally decomposed and is not effectively used. Further, there is a concern about an adverse effect on the environment, such as generation of organic fluorine compounds due to the thermal decomposition of fluoropolymer.

The present invention is made under circumstances described above, and a problem to be solved is to provide a method for recovering fluorine from a backsheet used in a solar panel, and a method for producing calcium fluoride.

### Means for solving the problem

In order to solve the above-described problem, research was conducted by the present inventors, and as a result, the present invention was completed by achieving a method of separating fluorine from fluoropolymer of a backsheet, etc., used in a solar panel, by applying alkaline treatment to the fluoropolymer to recover the fluorine in a presence of a catalyst.

That is, in order to solve the above-described problem, first invention provides a method for recovering fluorine from a backsheet used in a solar panel, which is a method for recovering fluorine from fluoropolymer of the backsheet containing the fluoropolymer and polyethylene terephthalate (PET) which are used in a solar panel, the method including:
applying alkaline treatment to the fluoropolymer to separate fluorine in a presence of a catalyst; and
causing a reaction between calcium and the separated fluorine to recover the fluorine as calcium fluoride.

Second invention provides a method for recovering fluorine from a backsheet used in a solar panel, which is a method for recovering fluorine from fluoropolymer of a backsheet containing fluoropolymer and PET which are used in a solar panel, the method including:
applying alkaline treatment to a mixture containing the fluoropolymer and the PET obtained from the backsheet, to remove the PET from the mixture by filtration; and thereafter,
applying alkaline treatment to the mixture from which the PET has been removed to separate fluorine in a presence of a catalyst.

Third invention provides the method for recovering fluorine from a backsheet used in a solar panel according to the first or second invention, wherein the backsheet is the one removed from a solar panel.

Fourth invention provides the method for recovering fluorine from a backsheet used in a solar panel according to any one of the first to third inventions, the method including:
crushing the backsheet to obtain a crushed product; and
performing the defluorination to the crushed product.

Fifth invention provides a method for recovering fluorine from a backsheet used in a solar panel according to the second invention, wherein the mixture containing the fluoropolymer and the PET is a crushed product obtained by crushing the backsheet.

Sixth invention provides the method for recovering fluorine from a backsheet used in a solar panel according to any one of the first to fourth inventions, wherein any one selected from quaternary ammonium hydroxide salts, quaternary ammonium chloride salts, quaternary ammonium bromide salts, and quaternary ammonium iodide salts, which are soluble in both water and organic solvents, is used as the catalyst.

Seventh invention provides the method for recovering fluorine from a backsheet used in a solar panel according to any one of the first to fifth inventions, wherein the fluoropolymer is polyvinylidene fluoride and/or polyvinyl fluoride.

Eighth invention provides a method for producing calcium fluoride from a backsheet used in a solar panel, which is a method for producing calcium fluoride from fluoropolymer of a backsheet containing fluoropolymer and PET which are used in a solar panel, the method including:
applying alkaline treatment to the fluoropolymer to separate fluorine in a presence of a catalyst; and
causing a reaction between the separated fluorine and calcium to generate calcium fluoride.

A nineth invention provides a method for producing calcium fluoride from a backsheet used in a solar panel, which is a method for producing calcium fluoride from fluoropolymer of a backsheet containing fluoropolymer and PET which are used in a solar panel, the method including:
removing the backsheet from a solar panel, then, crushing the backsheet to obtain a crushed product containing the fluoropolymer and PET which are obtained from the backsheet, and applying alkaline treatment to the crushed product to remove the PET from the mixture by filtration, and thereafter,
applying alkaline treatment to the mixture from which the PET has been removed to separate fluorine in a presence of a catalyst, and causing a reaction between calcium and the separated fluorine, to generate calcium fluoride.

### Advantage of the invention

According to the method for recovering fluorine from a backsheet used in a solar panel according to the present invention and the method for producing calcium fluoride, it becomes possible to recover fluorine from the fluoropolymer used in the backsheet and to produce calcium fluoride, and it becomes possible to recycle a plastic component that has been incinerated or landfilled without being effectively used.

### Brief description of the drawings

FIG. 1 is a schematic cross-sectional image of a solar panel.
FIG. 2 is a cross-sectional photograph of a mixture of fluoropolymer and PET used in a backsheet.
FIG. 3 is a schematic cross-sectional image of a solar cell sheet-like structure in which a glass substrate and a frame member are removed from the solar panel.
FIG. 4 is an appearance photograph of plastic particles comprising a mixture of fluoropolymer (PVDF) and PET according to example 1.
FIG. 5 is an appearance photograph of fluoropolymer (PVDF) particles according to example 1.
FIG. 6 is an appearance photograph of a white sediment according to example 1.
FIG. 7 is an appearance photograph of a residue of fluoropolymer (PVDF) particles and other impurity particles according to example 1.
FIG. 8 is an XRD spectrum of the white sediment according to example 1.
FIG. 9 shows the results of XRF analysis and ICP-AES analysis of the white sediment according to example 1.

### Detailed description of the invention

The present invention relates to a method for separating fluorine from fluoropolymer used in a backsheet, etc., used in a solar panel, by a wet method, recovering the fluorine, and producing calcium fluoride.

Hereinafter, embodiments for implementing the present invention will be described.

### 1. Configuration of a solar panel

The configuration of a solar panel and a backsheet of the solar panel will be briefly described, with reference to the drawings.

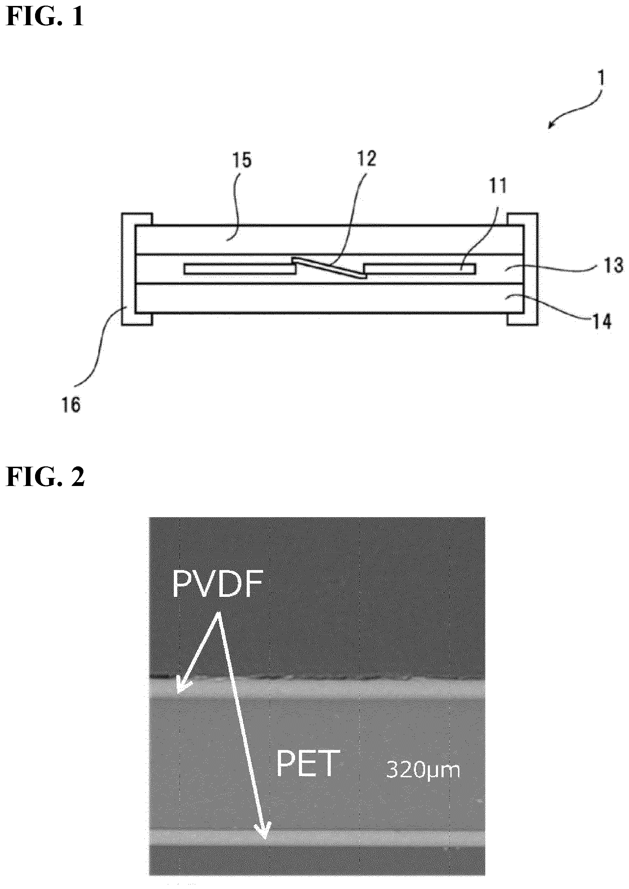

FIG. 1 is a schematic cross-sectional image of a solar panel.

As shown in FIG. 1, a solar panel 1 includes: a plurality of solar cells 11; a metal pattern 12 wired from the solar cells 11; an encapsulant 13 that seals the solar cells 11 and the metal pattern 12; a backsheet 14 provided on one surface of the encapsulant 13; a glass substrate 15 provided on the other surface of the encapsulant 13; and a frame member 16 surrounding a laminate including the encapsulant 13 and the glass substrate 15, etc.

In the solar panel 1, the solar cells 11 comprise a semiconductor containing silicon, for example. The metal pattern 12 is a metal member wired from the solar cells 11, and for example, includes surface electrodes provided on the surfaces of the solar cells 11 and bus bar electrodes electrically connecting the solar cells 11. The metal pattern 12 contains a valuable metal such as copper (Cu) and silver (Ag), and the surface electrodes mainly comprise Ag, and the busbar electrodes mainly comprise Cu. The encapsulant 13 comprises plastic such as ethylene-vinyl acetate (EVA) or polyethylene. The backsheet 14 comprises, for example, a mixture of fluoropolymer and PET. The glass substrate 15 comprises glass, for example. The frame member 16 comprises metal, plastic, etc., for example.

FIG. 2 is a cross-sectional photograph of an example of a mixture of fluoropolymer and PET which are used in the backsheet.

As shown in FIG. 2, the backsheet is a PET sheet laminated with a polyvinylidene fluoride (sometimes described as "PVDF" in the present invention) sheet on front and back sides or on one side thereof. In addition, there is a PET sheet laminated with a polyvinyl fluoride (sometimes described as "PVF" in the present invention) sheet on front and back sides or one side thereof.

### 2. Object for recovering fluorine

According to the present invention, fluorine is recovered from a backsheet containing fluoropolymer and PET which are used in a solar panel. In recovering fluorine from the backsheet containing fluoropolymer and PET, the backsheet taken out from the solar panel can be used. It is preferable to use a crushed backsheet in consideration of a recovery efficiency of fluorine. Further, a crushed product is obtained by crushing a solar cell sheet-like structure which is obtained by removing a glass substrate and a frame member from a solar panel, and this crushed product may be used as the object for recovering fluorine, by sorting to separate a backsheet component containing fluoropolymer and PET.

As the object for recovering fluorine, a solar panel 1 from which the backsheet 14 is removed can be used. Preferably, the removed backsheet 14 may be crushed to recover plastic particles comprising a mixture of fluoropolymer and PET.

Hereinafter, explanation will be given for a case in which the crushed product obtained by crushing the solar cell sheet-like structure which is obtained by removing the glass substrate and the frame member from the solar panel, is used as the object for recovering fluorine.

Several methods for crushing the solar cell sheet-like structure are known, including Japanese Patent No. 7021392 and Japanese Patent No. 7091571 disclosed by the present inventors. The solar cell sheet-like structure is crushed using these methods, and as the crushed product, plastic particles can be obtained, the plastic particles comprising the mixture of the fluoropolymer and PET derived from the above-described backsheet.

An example of the method for crushing a solar panel will be briefly described below.

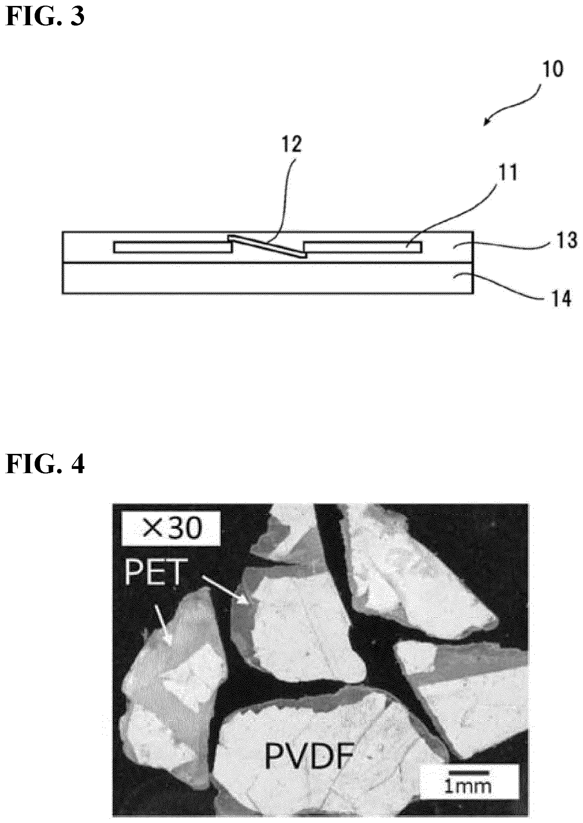

FIG. 3 is a schematic cross-sectional image of a solar cell sheet-like structure obtained by removing the glass substrate and the frame member from the solar panel.

After removing the glass substrate 15 and the frame member 16 from the solar panel 1 described above to obtain a solar cell sheet-like structure 10 shown in FIG. 3, this solar cell sheet-like structure 10 is subjected to crushing treatment and classification treatment.

Specifically, first, the solar cell sheet-like structure 10 (hereinafter also simply referred to as a sheet-like structure 10) is crushed. Thereby, a crushed product is formed containing particles derived from each member. The crushed product includes, for example, bonded particles in which a metal component and silicon are bonded, single metal particles, plastic particles, single silicon particles, etc.

The size of the crushed product is not particularly limited, but it is preferable to crush the sheet-like structure 10 so that the particle size of the crushed product is 10 mm or less, from a viewpoint of promoting the separation of the plastic from the metal or silicon, and from a viewpoint that it is preferable for the plastic particles to have a smaller particle size in the process of the "3. PET removal step" described later. More preferably, the backsheet may be crushed to 5 mm or less, and still more preferably 3 mm or less. By crushing in this way, the separation of each constituent material is promoted, and subsequent classification is facilitated.

As a crushing method, shear crushing capable of imparting a shearing action to the sheet-like structure 10 is preferable from a viewpoint of obtaining a fine particle size of the crushed product. As a crusher to be used, for example, a known crusher such as a uniaxial crusher or a biaxial crusher can be used, but the uniaxial crusher is preferable. The biaxial crusher provides coarse crushing depending on crushing conditions, thereby making it difficult to separate each constituent material in the subsequent stage. In contrast, the uniaxial crusher provides fine crushing, thereby facilitating separation of each constituent material in the subsequent stage. That is, according to the uniaxial crusher, the encapsulant 13 and the backsheet 14 can be finely crushed and easily separated from metal and silicon. The uniaxial crusher includes a uniaxial crusher and a uniaxial hammer mill depending on the shape of a blade, but the uniaxial crusher is preferable from a viewpoint of shear crushing.

The crushing condition is not particularly limited, and the number of blades in the crusher, the blade clearance, the number of rotations of the blades, etc., may be appropriately adjusted so that a particle size distribution of the crushed product is broadened. Further, the sheet-like structure 10 may be crushed in one step, or may be crushed gradually in multiple steps such as primary crushing and secondary crushing.

Each particle contained in the crushed product has a particle size according to a constituent material. For example, a member formed from a soft and sticky material such as plastic is crushed coarsely, and meanwhile a member formed from a hard and brittle material such as metal and silicon tend to be crushed into small pieces. Therefore, the particle size of the plastic particles in the crushed product is relatively large, and the particle size of the particles containing other components (such as single metal particles) is relatively small. That is, in the crushed product, the proportion of plastic, etc., is high and the proportion of a metal component is low in a large particle size range, and meanwhile, plastic, etc., is hardly mixed therein, and the proportion of the metal component is high in a small particle size range.

By utilizing the above-described difference in particle size, the plastic particles can be sorted from the bonded particles, the single metal particles, and the metal component of the single silicon particles.

Further, the plastic particles include plastic particles derived from the encapsulant 13 and plastic particles derived from the backsheet 14. Therefore, it is preferable to separate the plastic particles by using the difference in specific gravity and the difference in electrostatic properties of these plastic particles, to recover the plastic particles comprising the mixture of the fluoropolymer and the PET derived from the backsheet 14.

### 3. PET removal step

The plastic particles derived from the backsheet 14 contain composite particles of fluoropolymer and PET.

The composite particles have a structure in which fluoropolymer particles and PET are adhered, as shown in the photographic data of example 1 in FIG. 4, which will be described later. Therefore, it is preferable to remove the PET from the composite particles.

To remove the PET from the composite particles, alkaline treatment may be performed as follows: an alkaline aqueous solution with a concentration of 1 to 10 M (in the present invention, "M" means "mol/L".) is added so that the PET is sufficiently removed, then, the solution is heated to 90°C or higher, and stirred for 1 hour or longer. As the alkaline aqueous solution, a sodium hydroxide aqueous solution and a potassium hydroxide aqueous solution are preferable. A vessel made of SUS is preferable as a reaction vessel.

Then, the PET in the composite particles is decomposed into terephthalic acid and dissolved in the alkaline aqueous solution, thus producing a PET-dissolved solution. Therefore, the PET can be removed from the composite particles by filtering the solution using a known filter such as a filter paper, resulting in containing only fluoropolymer particles in the composite particles, but impurities such as titanium oxide contained in the PET may also be included. These impurities can be removed in the process of a post-step "6. Production step and recovery step for producing and recovering calcium fluoride". Therefore, the impurities can be removed by filtering the solution using a known filter such as a filter paper, and the fluoropolymer particles remaining on the filter can be recovered.

Note that if the solution becomes acidic at this time, precipitation of terephthalic acid occurs.

### 4. Step of pulverizing fluoropolymer particles

In the "5. Defluorination step" which is a post-step, the particle size of the fluoropolymer particles is preferably small, from a viewpoint of increasing a reaction rate of a defluorination reaction. On the other hand, in order to pulverize the fluoropolymer particles to obtain a small particle size, both pulverization time and pulverization energy are required.

Taking these into consideration, the recovered fluoropolymer particles are pulverized to a particle size of 1 mm or less, preferably 100 to 500 µm.

As a pulverization method, a known method can be used, and a uniaxial crusher or a mixer mill can be used.

In the step of pulverizing the fluoropolymer particles, the above-described "3. PET removal step" is very beneficial. This is because, the fact that the PET is a soft plastic is an obstacle when trying to pulverize the composite particles of the fluoropolymer and the PET, resulting in an increase of pulverization time and pulverization energy. According to the present invention, by performing a two-stage treatment in which the PET is removed from the composite particles in advance, and the composite particles are formed into fluoropolymer particles, and then the pulverization step and the "5. defluorination step" described later are performed, the increase of the pulverization time and pulverization energy due to the presence of PET can be avoided.

### 5. Defluorination step

According to the study by the present inventors, it is difficult to cause a reaction between the fluoropolymer particles and the alkaline aqueous solution to separate fluorine by alkaline treatment because the reaction rate is slow.

Here, as a result of the study by the present inventors, it is found that when the alkaline treatment is performed by causing a reaction between the fluoropolymer particles and the alkaline aqueous solution in the presence of a catalyst, fluorine can be separated from the fluoropolymer particles in a short reaction time.

Here, the catalyst used in the present invention will be described.

The catalyst used in the present invention is a so-called "phase transfer catalyst".

The phase transfer catalyst is a catalytic substance used to cause a reaction between a water-insoluble organic compound and an organic solvent-insoluble reagent. In the present invention, it is considered that OH⁻ is transferred from the alkaline aqueous solution to the fluoropolymer between two phases of the solid fluoropolymer and the liquid alkaline aqueous solution, and a nucleophilic attack of OH⁻ toward the ...-CH₂-CF₂-... chain is increased as described below.

Examples of the catalysts suitable for the defluorination reaction according to the present invention include quaternary ammonium salts having long-chain alkylammonium cations, crown ethers, and phosphonium compounds, which are soluble in both water and organic solvents.

Examples of the quaternary ammonium bromide salts soluble in both water and organic solvents include tetrabutylammonium bromide (sometimes referred to herein as "TBAB"), tetrapropylammonium bromide (sometimes referred to herein as "TPAB"), triethylbenzylammonium bromide (sometimes referred to herein as "TEBAB"), butylethylammonium bromide (sometimes referred to herein as "TBEAB"), ethyldecylammonium bromide (sometimes referred to herein as "TEDAB"), tetrabutylphosphonium bromide (sometimes referred to herein as "TBPB"), hexadecyltrimethylammonium bromide (sometimes referred to herein as "HTAB"), or tetrabutylphosphonium bromide (sometimes referred to as "TBPB").

Examples of the quaternary ammonium hydroxide salts soluble in both water and organic solvents include tetrabutylammonium hydroxide, tetrapropylammonium hydroxide, triethylbenzylammonium hydroxide, butylethylammonium hydroxide, ethyldecylammonium hydroxide, tetrabutylphosphonium hydroxide, hexadecyltrimethylammonium hydroxide, and tetrabutylphosphonium hydroxide.

Examples of the quaternary ammonium chloride salts soluble in both water and organic solvents include tetrabutylammonium chloride, tetrapropylammonium chloride, triethylbenzylammonium chloride, butylethylammonium chloride, ethyldecylammonium chloride, tetrabutylphosphonium chloride, hexadecyltrimethylammonium chloride, or tetrabutylphosphonium chloride.

Further examples of quaternary ammonium iodide salts soluble in both water and organic solvents include tetrabutylammonium iodide, tetrapropylammonium iodide, triethylbenzylammonium iodide, butylethylammonium iodide, ethyldecylammonium iodide, tetrabutylphosphonium iodide, hexadecyltrimethylammonium iodide or tetrabutylphosphonium iodide.

According to the studies by the present inventors, TBAB is preferable among these catalysts.

In order to separate fluorine from the fluoropolymer particles, sufficient alkaline aqueous solution with a concentration of 1 to 10 M is added, and the catalyst is added so that the concentration in the solution is 25 to 50 mM. The alkali contained in the alkaline aqueous solution to be added can be 0.05 mol or more per 1 g of the fluoropolymer particles. Then, the solution may be heated to 50°C or higher and stirred for 10 hours or longer to perform alkaline treatment. A sodium hydroxide aqueous solution is preferable as the alkaline aqueous solution, and a vessel made of SUS is preferable as a reaction vessel.

The alkaline aqueous solution used in the defluorination step and the alkaline aqueous solution used in the above-described "3. PET removal step" can be the same alkaline aqueous solution except for the presence or absence of a catalyst. Therefore, it is beneficial to use the same alkaline aqueous solution in both steps, from a viewpoint of a step management.

The present inventors consider the mechanism of separation of fluorine from the fluoropolymer particles by applying alkaline treatment to the fluoropolymer particles in the presence of a catalyst, and it is found as follows.

By nucleophilic reaction, OH⁻ attacks CH₂ of ... -CH₂-CF₂- ... chain of polyvinylidene fluoride, and ... -CH₂-CHF- ... chain of polyvinyl fluoride, which are fluoropolymer, to separate H⁺ therefrom. Subsequently, along with the separation of H⁺, ...-CH=CF-... chain or ...-CH=CH-... chain is formed, to thereby separate F⁻.

This reaction is usually slow, but the present inventors consider that the presence of the catalyst increases the activity of OH⁻ and increases the reaction rate.

### 6. A production step and a recovery step for producing and recovering calcium fluoride

Residues of fluoropolymer particles and impurities derived from the PET such as titanium oxide, remaining on the filter are removed from the solution containing fluorine ions obtained in the defluorination step, using a known filter such as a filter paper. Then, the resulting solution is neutralized to neutrality, and a sufficient calcium ion source, such as calcium chloride, in an amount more than the molar equivalents of the present fluoride ions, is also added to the solution. By using calcium chloride, in the production step and the recovery step, calcium fluoride is sufficiently produced and recovered from fluoride ions while avoiding the production of calcium carbonate due to dissolution of carbon dioxide in the air.

### 7. Different embodiment

In the embodiment described above, the "step of removing the PET from the fluoropolymer fine particles" and the "defluorination step of separating fluorine from the fluoropolymer fine particles" were performed as separate steps. However, these steps can also be performed simultaneously, from a viewpoint of step simplification.

In this case, the plastic particles comprising the mixture of fluoropolymer and PET derived from the backsheet recovered from the solar panel, are pulverized by the method described in "4. Step of pulverizing fluoropolymer particles", and the alkaline aqueous solution having a concentration of 1 to 10 M is sufficiently added to the obtained plastic particles comprising the mixture of the fluoropolymer and PET, and the catalyst is added so as to have a concentration of 25 to 50 mM in the solution, and the solution is heated to 50°C or higher, stirred for 10 hours or longer.

Then, the "PET removal step" and the "defluorination step" proceed at the same time. Therefore, the residues of the fluoropolymer fine particles, impurities derived from PET such as titanium oxide, etc., are removed from the solution containing separated fluorine ions, using a known filter such as a filter paper. Then, the resulting solution is neutralized to neutrality, and further a calcium ion source such as calcium chloride is added to the solution. By using calcium chloride, fluoride ions can be recovered as calcium fluoride while suppressing the generation of calcium carbonate.

### Examples

Hereinafter, the present invention will be specifically described with reference to examples. However, the present invention is not limited to the following examples.

### (Example 1)

A backsheet was prepared by removing a glass substrate, a frame member, solar cells, etc. from a solar panel. The backsheet is a mixture in which PVDF sheets are laminated on the front and back sides of a PET sheet. Subsequently, the backsheet was crushed until it passes through a 3 mm screen and was crushed to 3 mm or less, using a uniaxial crusher, and in the case of not passing through, the processing was repeated. FIG. 4 shows an appearance photograph of the plastic particles comprising the mixture of the PVDF and PET.

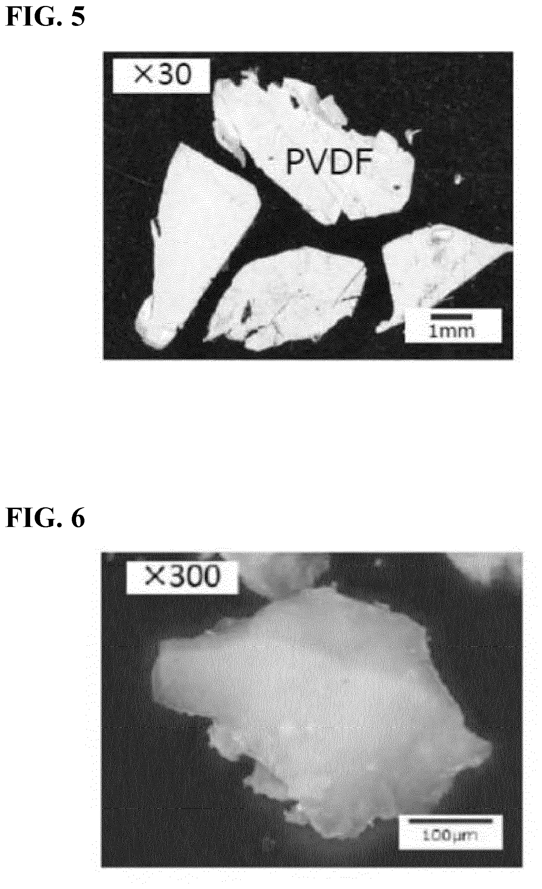

100 ml of 4 M sodium hydroxide aqueous solution was added to 10 g of the mixture of recovered PVDF and PET (an amount of fluorine is 0.93 g), and the solution was heated to 90°C, stirred for 10 hours, and subjected to alkaline treatment, to obtain a first alkaline treatment liquid, and only PET was decomposed from the plastic particles comprising the mixture of PVDF and PET. A vessel made of SUS304 was used as a reaction vessel. Thereafter, the first alkaline treatment liquid was filtered using a filter paper, and the fluoropolymer (PVDF) particles remaining on the filter paper were recovered. FIG. 5 shows an appearance photograph of the recovered fluoropolymer (PVDF) particles.

The recovered fluoropolymer (PVDF) particles were pulverized using a mixer mill to obtain fluoropolymer (PVDF) particles having an average particle size of 100 µm.

A second alkaline treatment liquid was obtained by the defluorination step including: adding 100 ml of an aqueous sodium hydroxide solution with a concentration of 4 M, to 2 g of the pulverized fluoropolymer (PVDF) particles, further adding TBAB as a catalyst to have a concentration of 50 mM, and heating the solution to 90°C, stirring the solution for 10 hours, to separate fluorine ions from fluoropolymer (PVDF). A vessel made of SUS304 was used as a reaction vessel.

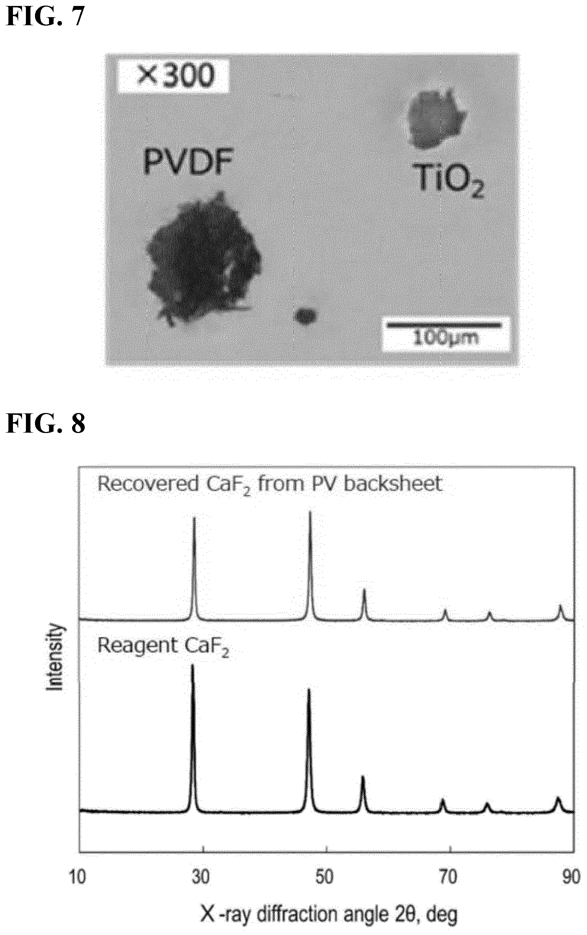

After the defluorination step, the second alkaline treatment liquid was filtered using a filter paper, to remove the residues of defluorinated fluoropolymer (PVDF) particles and impurities such as titanium oxide, remaining on the filter paper. Then, pH of the solution was adjusted to neutrality. Thereafter, the recovery step was performed as follows: calcium chloride was added in an amount 1.5 times the molar ratio of fluorine to generate a white sediment and recover the white sediment using a filter paper. Thus, 1.68 g of white sediment was recovered. FIG. 6 shows an appearance photograph of the white sediment. On the other hand, FIG. 7 shows an appearance photograph of the residue of defluorinated fluoropolymer (PVDF) particles and impurities derived from the PET such as titanium oxide contained in the PET, remaining on the filter paper.

Analysis results of the recovered white sediment will be described.

FIG. 8 shows the XRD spectra of the recovered white sediment and a calcium fluoride reagent. In FIG. 8, an upper column shows the XRD spectrum of the white sediment according to example 1, and a lower column shows the XRD spectrum of the reagent (calcium fluoride manufactured by Wako). By comparing both XRD spectra, it was confirmed that the white sediment had a spectrum specific to calcium fluoride.

Further, wavelength dispersive XRF analysis result for the white sediment according to example 1 reveals that the white sediment contains 97.5% calcium fluoride as a constituent substance, and an amount of fluorine contained was found to be 0.82 g. Accordingly, the recovery of fluorine over an entire step according to example 1 was found to be 88%.

Further, ICP-AES analysis result for S, As, Pb, etc., reveals that the content of impurities such as As and Pb contained in the white sediment according to example 1, satisfies a quality standard applied to commercial acid grade and metallurgical/ceramic grade fluorite.

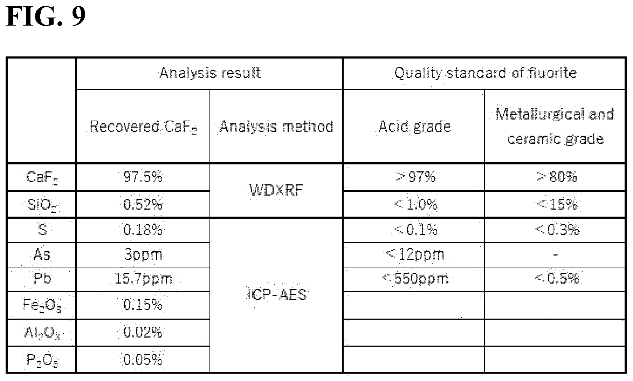

The table of FIG. 9 shows analysis results of XRF analysis and ICP-AES analysis for the white sediment according to example 1, and the quality standard items applied to acid grade and metallurgical/ceramic grade fluorite.

As described above, it was found that calcium fluoride that satisfies recycling quality can be recovered and produced from the backsheet of a solar panel.

## Claims

1. A method for recovering fluorine from a backsheet used in a solar panel, which is a method for recovering fluorine from fluoropolymer of the backsheet containing the fluoropolymer and PET which are used in a solar panel, the method including:
applying alkaline treatment to the fluoropolymer to separate fluorine in a presence of a catalyst; and
causing a reaction between calcium and the separated fluorine to recover the fluorine as calcium fluoride.

2. A method for recovering fluorine from a backsheet used in a solar panel, which is a method for recovering fluorine from fluoropolymer of a backsheet containing fluoropolymer and PET which are used in a solar panel, the method including:
applying alkaline treatment to a mixture containing the fluoropolymer and the PET obtained from the backsheet, to remove the PET from the mixture by filtration; and thereafter,
applying alkaline treatment to the mixture from which the PET has been removed to separate fluorine, in a presence of a catalyst.

3. The method for recovering fluorine from a backsheet used in a solar panel according to claim 1 or 2, wherein the backsheet is the one removed from a solar panel.

4. The method for recovering fluorine from a backsheet used in a solar panel according to claim 1, the method including:
crushing the backsheet to obtain a crushed product; and
performing the defluorination to the crushed product.

5. A method for recovering fluorine from a backsheet used in a solar panel according to claim 2, wherein the mixture containing the fluoropolymer and the PET is a crushed product obtained by crushing the backsheet.

6. The method for recovering fluorine from a backsheet used in a solar panel according to claim 1 or 2, wherein any one selected from quaternary ammonium hydroxide salts, quaternary ammonium chloride salts, quaternary ammonium bromide salts, and quaternary ammonium iodide salts, which are soluble in both water and organic solvents, is used as the catalyst.

7. The method for recovering fluorine from a backsheet used in a solar panel according to claim 1 or 2, wherein the fluoropolymer is polyvinylidene fluoride and/or polyvinyl fluoride.

8. A method for producing calcium fluoride from a backsheet used in a solar panel, which is a method for producing calcium fluoride from fluoropolymer of a backsheet containing fluoropolymer and PET which are used in a solar panel, the method including:
applying alkaline treatment to the fluoropolymer to separate fluorine in a presence of a catalyst; and
causing a reaction between the separated fluorine and calcium to generate calcium fluoride.

9. A method for producing calcium fluoride from a backsheet used in a solar panel, which is a method for producing calcium fluoride from fluoropolymer of a backsheet containing fluoropolymer and PET which are used in a solar panel, the method including:
removing the backsheet from a solar panel, then, crushing the backsheet to obtain a crushed product containing the fluoropolymer and PET which are obtained from the backsheet, and applying alkaline treatment to the crushed product to remove the PET from the mixture by filtration, and thereafter,
applying alkaline treatment to the mixture from which the PET has been removed to separate fluorine in a presence of a catalyst, and causing a reaction between calcium and the separated fluorine, to generate calcium fluoride.
